# EUROPÄISCHE PATENTSCHRIFT

(11) **EP 2 906 030 B1**
(45) Veröffentlichungstag und Bekanntmachung des Hinweises auf die Patenterteilung: **19.09.2018**
(21) Anmeldenummer: 14154688.7
(22) Anmeldetag: 11.02.2014
(51) Int. Cl.: H05K 9/00

(54) **Elektronische Baugruppe mit elektrisch leitfähiger Verbindung**
Electronic assembly with electrically conductive connection
Module électronique doté d'une liaison conductrice d'électricité

(43) Veröffentlichungstag der Anmeldung: 12.08.2015
(73) Patentinhaber: Siemens Aktiengesellschaft, 80333 München (DE)
(72) Erfinder: Gramolla, Tobias, 92245 Kümmersbruck (DE); Mankut, Oliver, 90518 Altdorf (DE); Meier, Patrick, 90518 Altdorf b. Nürnberg (DE); Stein, Ulf, 92224 Amberg (DE)

(56) Entgegenhaltungen:
- EP-A1- 1 499 172
- US-A1- 2009 183 912
- US-A1- 2010 126 766
- US-A1- 2011 128 715

## Beschreibung

Die Erfindung betrifft eine elektronische Baugruppe umfassend zumindest ein erstes metallisches Gehäuseteil und ein zweites metallisches Gehäuseteil, welche derart ausgestaltet sind, dass sie in einem zusammengebauten Zustand ein Gehäuse für die Baugruppe bilden, wobei das erste Gehäuseteil zumindest eine Fügefläche und das zweite Gehäuseteil zumindest eine Gegenfügefläche aufweist, welche im zusammengebauten Zustand aufeinander stehen.

Damit elektronische Baugruppen bei Installation und anschließendem Betrieb, insbesondere in der Automatisierungstechnik, die notwendige elektromagnetische Verträglichkeit aufweisen, müssen bestimmte Regeln beachtet werden. Elektrisch leitfähige Verbindungen von metallischen Gehäuseteilen und Anbindungen an ein Masse-/Erdsystem müssen sicher gewährleistet sein, um die gesetzlichen Anforderungen hinsichtlich elektromagnetischer Verträglichkeit (Störfestigkeit und Störaussendung) zu erfüllen.

Dem Fachmann bekannte Lösungen sind beispielsweise Schraubverbindungen, Federn, EMV-Dichtungen, wie z.B. Drahtgeflechte, sowie Steckverbinder oder Kabel und Draht-/Blechbügel. Diese Lösungen beinhalten unterschiedliche Nachteile hinsichtlich der Komplexität und der Konstruktion und damit Kostennachteile, bzw. Temperaturempfindlichkeit (z.B. Klebstoffe bei EMV-Dichtungen), Korrosion der Kontaktpartner, mangelnde mechanische Stabilität, z.B. bei starker mechanischer Beanspruchung, und zum Teil hohen Platzbedarf.

Die Schrift US 2011/0128715 A1 offenbart ein Gehäuse mit einem ersten metallischen Gehäuseteil und einem zweiten metallischen Gehäuseteil, welche miteinander verschraubbar ausgestaltet sind.

Es ist Aufgabe der vorliegenden Erfindung die EMV-Verträglichkeit, also die elektromagnetische Verträglichkeit hinsichtlich einer Störfestigkeit einer elektronischen Baugruppe und einer Störaussendung einer elektronischen Baugruppe zu verbessern.

Die Aufgabe wird bei einer elektronischen Baugruppe umfassend zumindest ein erstes metallisches Gehäuseteil und ein zweites metallisches Gehäuseteil, welche derart ausgestaltet sind, dass sie in einem zusammengebauten Zustand ein Gehäuse für die Baugruppe bilden, wobei das erste Gehäuseteil zumindest eine Fügefläche und das zweite Gehäuseteil zumindest eine Gegenfügefläche aufweist, welche im zusammengebauten Zustand aufeinander stehen, dadurch gelöst, dass die zumindest eine Fügefläche ein Kontaktmittel aufweist, welches ausgestaltet ist im zusammengebauten Zustand derart mit der Gegenfügefläche zusammenzuwirken, dass an der Stelle des Kontaktmittels eine die Gehäuseteile umgebene Isolierschicht durchbrochen wird und ein elektrischer Kontakt zwischen den beiden Gehäuseteilen besteht, wobei die Kontaktmittel in der Fügefläche als spitz zulaufende Ausprägungen aus der Fügefläche heraus ausgestaltet.

Damit eine elektronische Baugruppe mit einem metallischen Gehäuse die vom Gesetzgeber vorgeschriebene elektromagnetische Verträglichkeit aufweist, sollten alle elektrischen metallischen Verbindungen bzw. Masse-Erdsysteme eine niederimpedante Verbindung aufweisen. Eine niederimpedante Verbindung wird in der Regel durch gut leitende Metall-Metall-Verbindungen erreicht, auch die Verwendung flexibler Massebänder mit kurzen Verbindungsleitungen mit großer Ober- oder Kontaktfläche lassen eine niederimpedante Verbindung zu. Insbesondere bei lackierten, eloxierten oder isolierten Metallteilen im Bereich einer Verbindungsstelle wirkt die isolierende Schicht auf den Gehäuseteilen einer niederimpedanten Verbindung entgegen.

Erfindungsgemäß sind nun an den Verbindungsstellen bzw. an den Fügeflächen Kontaktmittel in Form von Dornen vorhanden.

Diese Dornen stellen durch ihr Eindringen in die Gegenfügefläche eines anderen metallischen Gehäuseteils eine sichere elektrische Verbindung der zu verbindenden Gehäuseteile her. Mit dieser durch die Dornen hergestellten elektrischen Verbindung ist zwischen den Gehäuseteilen eine niederimpedante Verbindung realisiert. Die Isolierschicht, wie z.B. eine Oberflächenveredelung, Passivierung oder Lackierung wird durch die Dornen sicher durchdrungen.

Vorteilhafter Weise wird die Gegenfügefläche ein Gegenkontaktmittel aufweisen, welches derart ausgestaltet ist, dass das Kontaktmittel der Fügefläche von dem Gegenkontaktmittel der Gegenfügefläche zumindest teilweise umgeben ist.

Zur weiteren Verbesserung der elektromagnetischen Verträglichkeit der elektronischen Baugruppe weist zumindest ein Gehäuseteil eine weitere Fügefläche auf, welche mit weiteren Kontaktmitteln versehen ist und die weitere Fügefläche ist derart ausgestaltet, dass ein metallischer Streifen angeordnet auf einer Leiterplatte innerhalb des Gehäuses mit den weiteren Kontaktmitteln eine elektrische Verbindung eingeht. Mit dieser Ausgestaltung kann eine niederimpedante Verbindung mit einem metallischen Rand der Leiterplatte zum Gehäuse hergestellt werden.

Als vorteilhaft hat sich herausgestellt, wenn ein Werkstoff des Kontaktmittels eine Festigkeit aufweist, welche größer ist, als eine Festigkeit eines Werkstoffes der Gegenfügefläche. Durch die Platzierung beispielsweise eines Dorn im Material mit der höheren Festigkeit wird ein sicheres Eindringen des Dornes und damit eine sichere elektrische Verbindung mit dem Gegenmaterial erreicht.

Mit der Zeichnung wird ein Ausführungsbeispiel aufgezeigt. Dabei zeigt die
- FIG 1: eine zusammengebaute elektronische Baugruppe,
- FIG 2: ein erstes Gehäuseteil des Gehäuses der elektronischen Baugruppe und
- FIG 3: ein zweites Gehäuseteil des Gehäuses der elektronischen Baugruppe.

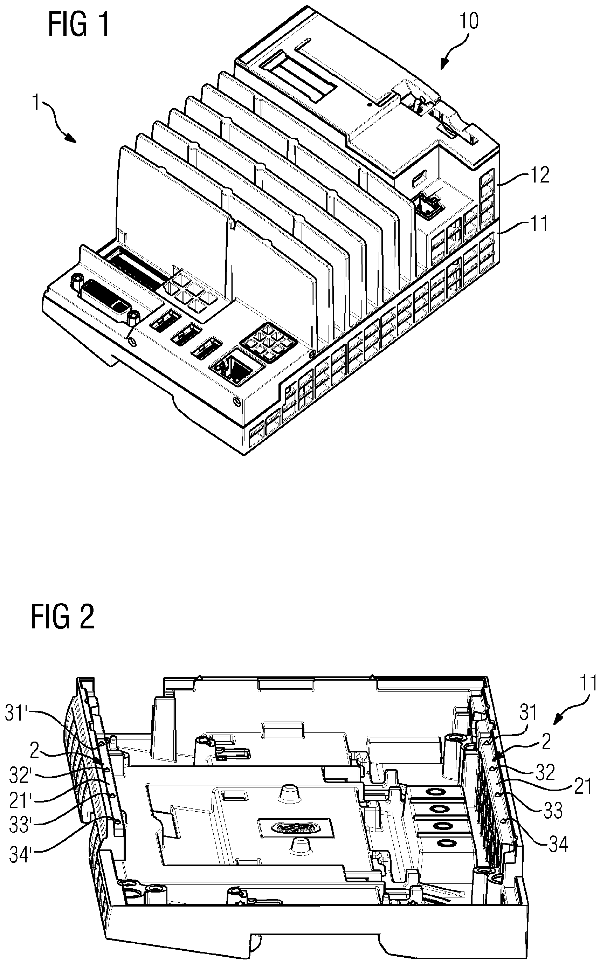

Gemäß FIG 1 ist eine elektronische Baugruppe 1 mit einem ersten metallischen Gehäuseteil 11 und einem zweiten metallischen Gehäuseteil 12 dargestellt. Die beiden metallischen Gehäuseteile 11,12 bilden im zusammengebauten Zustand ein Gehäuse 10 für die elektronische Baugruppe 1.

Damit die elektrisch leitfähige Verbindung der Gehäuseteile 11,12 miteinander und eine anschließende Anbindung an ein Masse-/Erdsystem sicher gewährleistet ist und um die gesetzlichen Anforderungen hinsichtlich elektromagnetischer Verträglichkeit zu erfüllen, weist das erste Gehäuseteil 11 gemäß FIG 2 eine erste Fügefläche 21 und eine zweite Fügefläche 21' auf. Die erste Fügefläche 21 und die zweite Fügefläche 21' weisen jeweils ein Kontaktmittel 2 auf, welches ausgestaltet ist, im zusammengebauten Zustand des Gehäuses 10 derart mit einer Gegenfügefläche 22 und zweiten Gegenfügefläche 22' zusammenzuwirken, dass an der Stelle des Kontaktmittels 2 eine die Gehäuseteile 11,12 umgebene Isolierschicht durchbrochen wird und ein elektrischer Kontakt zwischen den beiden Gehäuseteilen 11,12 besteht.

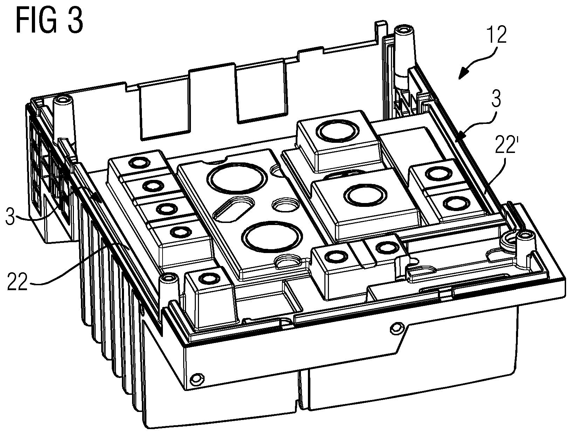

Die Kontaktmittel 2 in der ersten Fügefläche 21 und der zweiten Fügefläche 21' sind als spitz zulaufende Dornen aus der Fügefläche 21,21' heraus ausgestaltet. Das Material der spitz zulaufenden Dornen ist von der Festigkeit ein Material mit höherer Festigkeit gegenüber dem Material der Gegenfügefläche 22,22' mit dem Gegenkontaktmittel 3, siehe FIG 3.

Wird das erste metallische Gehäuseteil 11 gemäß FIG 2 auf das zweite metallische Gehäuseteil 12 gemäß FIG 3 aufgesetzt und zusammengepresst, beispielsweise über die vier dargestellten Schraubverbindungen, so dringen die in FIG 2 gezeigten Kontaktmittel 2 in das Gegenkontaktmittel 3 der Gegenfügeflächen 22,22' des zweiten metallischen Gehäuseteils 11 ein.

Das Kontaktmittel 2 in der Fügefläche 21,21' ist als eine Reihe von spitz zulaufenden Dornen ausgestaltet. In der ersten Fügefläche 21 und in der zweiten Fügefläche 21' sind jeweils ein erster Dorn 31,31', ein zweiter Dorn 32,32', ein dritter Dorn 33,33' und ein vierter Dorn 34,34' angeordnet.

Die Anordnung der Dornen auf den Fügeflächen oder generell auf Kontaktelementen kann in beliebigen Abständen und in beliebig hoher Bestückungsdichte erfolgen.

Als weitere erfindungsgemäße Vorteile sind zu nennen:
Einfaches sicherstellen der EMV-Anforderungen durch elektrischen Kontakt zwischen allen Teilen der Baugruppe/des Gerätes. Herstellen einer gasdichten Verbindung zwischen zwei Gehäuseteilen. Aufbrechen einer isolierenden Oberfläche zur Sicherstellung des elektrischen Kontaktes, z.B. bei Durchdringen von Lackschichten. Leitfähige Verbindung der Gehäuseteile und/oder Schirmbleche ist nunmehr kostenneutral realisierbar. Da diese Herstellung werkzeuggebunden ist, also zusätzliche Elemente, Bauteile oder Dichtungen nicht benötigt werden.

## Patentansprüche

1. Elektronische Baugruppe (1) umfassend zumindest ein erstes metallisches Gehäuseteil (11) und ein zweites metallisches Gehäuseteil (12), welche derart ausgestaltet sind, dass sie in einem zusammengebauten Zustand ein Gehäuse (10) für die Baugruppe (1) bilden, wobei das erste Gehäuseteil (11) zumindest eine Fügefläche (21,21') und das zweite Gehäuseteil zumindest eine Gegenfügefläche (22,22') aufweist, welche im zusammengebauten Zustand aufeinander stehen,
**dadurch gekennzeichnet, dass** die zumindest eine Fügefläche (21,21') ein Kontaktmittel (2) aufweist, welches ausgestaltet ist im zusammengebauten Zustand derart mit der Gegenfügefläche (22,22') zusammenzuwirken, dass an der Stelle des Kontaktmittels (2) eine die Gehäuseteile (11,12) umgebende Isoliersicht durchbrochen wird und ein elektrischer Kontakt zwischen den beiden Gehäuseteilen (11,12) besteht, wobei das Kontaktmittel (2) in der Fügefläche (21,21') als spitz zulaufende Ausprägung aus der Fügefläche (21,21') heraus ausgestaltet ist.

2. Elektronische Baugruppe (1) nach Anspruch 1, wobei die Gegenfügefläche (22,22') ein Gegenkontaktmittel (3) aufweist, welches derart ausgestaltet ist, dass das Kontaktmittel (2) der Fügefläche (21,21') von dem Gegenkontaktmittel (3) der Gegenfügefläche (22,22') zumindest teilweise umgeben ist.

3. Elektronische Baugruppe (1) nach einem der Ansprüche 1 oder 2, wobei zumindest ein Gehäuseteil (11,12) eine weitere Fügefläche (21,21') aufweist, welche mit weiteren Kontaktmitteln (2) versehen ist und die weitere Fügefläche (21,21') derart ausgestaltet ist, dass ein metallischer Streifen angeordnet auf einer Leiterplatte innerhalb des Gehäuses (10) mit den weiteren Kontaktmitteln eine elektrische Verbindung eingeht.

4. Elektronische Baugruppe (1) nach einem der Ansprüche 1 bis 3, wobei ein Werkstoff des Kontaktmittels (2) eine Festigkeit aufweist, welche größer ist als eine Festigkeit eines Werkstoffes der Gegenfügefläche (22,22').

## Claims

1. Electronic assembly (1) comprising at least a first metallic housing part (11) and a second metallic housing part (12), which are configured such that they form a housing (10) for the assembly (1) in an assembled state, wherein the first housing part (11) has at least one joining surface (21, 21') and the second housing part has at least one counter-joining surface (22, 22'), which stand on top of one another in the assembled state,
**characterised in that** the at least one joining surface (21, 21') has a contact means (2), which is configured in the assembled state to interact with the counter-joining surface (22, 22') such that an insulating layer surrounding the housing parts (11, 12) is penetrated at the point of the contact means (2) and there is an electrical contact between the two housing parts (11, 12), wherein the contact means (2) in the joining surface (21, 21') is configured as a shape tapering out from the joining surface (21, 21').

2. Electronic assembly (1) according to claim 1, wherein the counter-joining surface (22, 22') has a counter-contact means (3), which is configured such that the contact means (2) of the joining surface (21, 21') is at least partially surrounded by the counter-contact means (3) of the counter-joining surface (22, 22').

3. Electronic assembly (1) according to one of claims 1 or 2, wherein at least one housing part (11, 12) has a further joining surface (21, 21'), which is provided with further contact means (2) and the further joining surface (21, 21') is configured such that a metallic strip arranged on a circuit board within the housing (10) enters into an electrical connection with the further contact means.

4. Electronic assembly (1) according to one of claims 1 to 3, wherein a material of the contact means (2) has a strength which is greater than a strength of a material of the counter-joining surface (22, 22').

## Revendications

1. Module (1) électronique, comprenant au moins une première partie (11) métallique de boîtier et une deuxième partie (12) métallique de boîtier, qui sont conformées de manière à former, à l'état assemblé, un boîtier (10) du module (1), la première partie (11) du boîtier ayant au moins une surface (21, 21') de joint et la deuxième partie du boîtier ayant au moins une contre surface (22, 22') de joint, qui sont l'une sur l'autre à l'état monté,
**caractérisé en ce que** la au moins une surface (21, 21') de joint a un moyen (2) de contact, conformé pour coopérer, à l'état monté, avec la contre surface (22, 22') de joint, de manière à interrompre, au point du moyen (2) de contact, une couche isolante entourant les parties (11, 12) du boîtier et à constituer un contact électrique entre les deux parties (11, 12) du boîtier, le moyen (2) de contact, dans la surface (21, 21') de joint, étant conformé sous la forme d'un estampage sortant en pointe de la surface (21, 21') de joint.

2. Module (1) électronique suivant la revendication 1, dans lequel la contre surface (22, 22') de joint a un contre moyen (3) de contact, conformé de manière à ce que le moyen (2) de contact de la surface (21, 21') de joint soit entouré, au moins en partie, par le contre moyen (3) de contact de la contre surface (22, 22') de joint.

3. Module (1) électronique suivant l'une des revendications 1 ou 2, dans lequel au moins une partie (11, 12) du boîtier a une autre surface (21, 21') de joint, qui est pourvue d'autres moyens (2) de contact, et l'autre surface (21, 21') de joint est conformée de manière à ce qu'une bande métallique, disposée sur une plaquette à circuit imprimé à l'intérieur du boîtier (10), entre en liaison électrique avec les autres moyens de contact.

4. Module (1) électronique suivant l'une des revendications 1 à 3, dans lequel un matériau du moyen (2) de contact a une résistance mécanique plus grande qu'une résistance mécanique d'un matériau de la contre surface (22, 22') de joint.
